# EUROPEAN PATENT APPLICATION

(11) **EP 2 565 939 A1**
(43) Date of publication of application: **06.03.2013**
(21) Application number: 11775030.7
(22) Date of filing: 27.04.2011
(51) Int. Cl.: H01L 31/072

(54) **PHOTOELECTRIC CONVERSION ELEMENT, PHOTOELECTRIC CONVERSION DEVICE, AND METHOD FOR MANUFACTURING PHOTOELECTRIC CONVERSION ELEMENT**

(30) Priority: 29.10.2010 JP 2010242990; 26.05.2010 JP 2010120084; 27.04.2010 JP 2010102517
(71) Applicant: Kyocera Corporation, Kyoto-shi Kyoto 612-8501 (JP)
(72) Inventor: OOMAE, Satoshi, Fushimi-ku, Kyoto-shi Kyoto 6128501 (JP); ABE, Shinichi, Fushimi-ku, Kyoto-shi Kyoto 6128501 (JP); FUKUDOME, Masato, Higashiomi-shi Shiga 527-8555 (JP); OOKUMA, Takeshi, Fushimi-ku, Kyoto-shi Kyoto 6128501 (JP); SHIRASAWA, Katsuhiko, Fushimi-ku, Kyoto-shi Kyoto 6128501 (JP); NISHIMURA, Takehiro, Fushimi-ku, Kyoto-shi Kyoto 6128501 (JP); TOYOTA, Daisuke, Fushimi-ku, Kyoto-shi Kyoto 6128501 (JP); SANO, Hirotaka, Fushimi-ku, Kyoto-shi Kyoto 6128501 (JP); KUROSU, Keita, Fushimi-ku, Kyoto-shi Kyoto 6128501 (JP)
(74) Representative: Witte, Weller & Partner
(86) International application number: PCT/JP2011/060216
(87) International publication number: WO 2011/136249

(57) **Abstract**

[Problem]

In the case of further stacking a window layer or the like on a buffer layer, the buffer layer and the light absorption layer are likely to be damaged during the formation of the window layer due to inferior moisture resistance and plasma resistance, and photoelectric conversion elements sometimes fail to achieve any satisfactory conversion efficiency in terms of reliability.

[Solving Means]

Provided is a photoelectric conversion element including: a light absorption layer containing a I-B group element, a III-B group element, and a VI-B group element, which is provided on a lower electrode layer; a first semiconductor layer containing a III-B group element and a VI-B group element, which is provided on the light absorption layer; and a second semiconductor layer containing an oxide of a II-B group element, which is provided on the first semiconductor layer, wherein the light absorption layer comprises a doped layer region containing the II-B group element, on the first semiconductor layer side.

## Description

### Technical Field

The present invention relates to a photoelectric conversion element, a photoelectric conversion device, and a method for manufacturing a photoelectric conversion element.

### Background Art

Photoelectric conversion devices for use in solar power generation include photoelectric conversion devices with a light absorption layer made of a chalcopyrite-based I-III-VI group compound semiconductor such as CIGS which has a high light absorption coefficient. The CIGS is suitable for the reduction in film thickness, increase in area, and reduction in cost for photoelectric conversion devices, and research and development have been advanced on next-generation solar cells using this CIGS.

This type of chalcopyrite-based photoelectric conversion device comprises a configuration with a plurality of photoelectric conversion elements provided adjacent to each other in planar fashion. This photoelectric conversion element is configured by stacking, on substrate such as glass, a lower electrode such as a metal electrode, a photoelectric conversion layer that is a semiconductor layer including a light absorption layer and a buffer layer, and an upper electrode such as a transparent electrode and a metal electrode in this order. Furthermore, the plurality of photoelectric conversion elements are connected electrically in series by electrically connecting the upper electrode of one of adjacent photoelectric conversion elements to the lower electrode of the other photoelectric conversion element through a connecting conductor.

In recent years, a method has been known in which Zn is diffused directly in a light absorption layer of CIGS. For example, as described in Japanese Patent Application Laid-Open No. 2004-15039, a method is disclosed in which an n-type semiconductor is diffused in a light absorption layer of CIGS when ZnS that is a buffer layer is deposited by a CBD method (chemical bath deposition method).

### Summary of Invention

However, in the case of further stacking a window layer or the like on a buffer layer, the buffer layer of ZnS and the light absorption layer are likely to be damaged during the formation of the window layer due to inferior moisture resistance and plasma resistance of the buffer layer, thereby making it difficult to increase the conversion efficiency of the photoelectric conversion element.

An object of the present invention is to improve a photoelectric conversion element and a photoelectric conversion device in conversion efficiency.

A photoelectric conversion element according to an embodiment of the present invention includes: a light absorption layer containing a I-B group element, a III-B group element, and VI-B group element, which is provided on a lower electrode layer; a first semiconductor layer containing a III-B group element and a VI-B group element, which is provided on the light absorption layer; and a second semiconductor layer containing an oxide of a II-B group element, which is provided on the first semiconductor layer, wherein the light absorption layer comprises a doped layer region containing the II-B group element, on the first semiconductor layer side.

Furthermore, a method for manufacturing a photoelectric conversion element according to an embodiment of the present invention includes a stacking step and a diffusing step. The stacking step is a step of sequentially forming, on a lower electrode layer, a light absorption layer containing a I-B group element, a III-B group element, and a VI-B group element, a first semiconductor layer containing a III-B group element and a VI-B group element, and a second semiconductor layer containing an oxide of a II-B group element. In addition, the diffusing step is a step of diffusing the II-B group element from the second semiconductor layer through the first semiconductor layer to the light absorption layer, after the stacking step.

Furthermore, a method for manufacturing a photoelectric conversion element according to an embodiment of the present invention includes the following steps. The first step is a step of sequentially forming, on a lower electrode layer, a light absorption layer containing a I-B group element, a III-B group element, and a VI-B group element, and a first semiconductor layer containing a III-B group element and a VI-B group element. The next step is a step of depositing, on the first semiconductor layer, a second semiconductor layer containing an oxide of a II-B group element while implanting the II-B group element through the first semiconductor layer into the light absorption layer.

Furthermore, a photoelectric conversion device according to an embodiment of the present invention uses the photoelectric conversion element described above.

### Effects of the Invention

The embodiment of the present invention makes it possible to improve the photoelectric conversion element and the photoelectric conversion device in conversion efficiency.

### Brief Description of Drawings

Fig. 1 is a top view illustrating a configuration of a photoelectric conversion device according to the present embodiment.
Fig. 2 is a cross-sectional pattern diagram of a photoelectric conversion element according to the present embodiment.
Fig. 3 is a manufacturing process for a photoelectric conversion element according to the present embodiment.
Fig. 4 is a photograph of a cross section of a photoelectric conversion element according to the present embodiment.

### Embodiment for Carrying Out the Invention

An embodiment of the present invention will be described below with reference to the drawings.

### <Schematic Configurations of Photoelectric Conversion Element and Photoelectric Conversion Device>

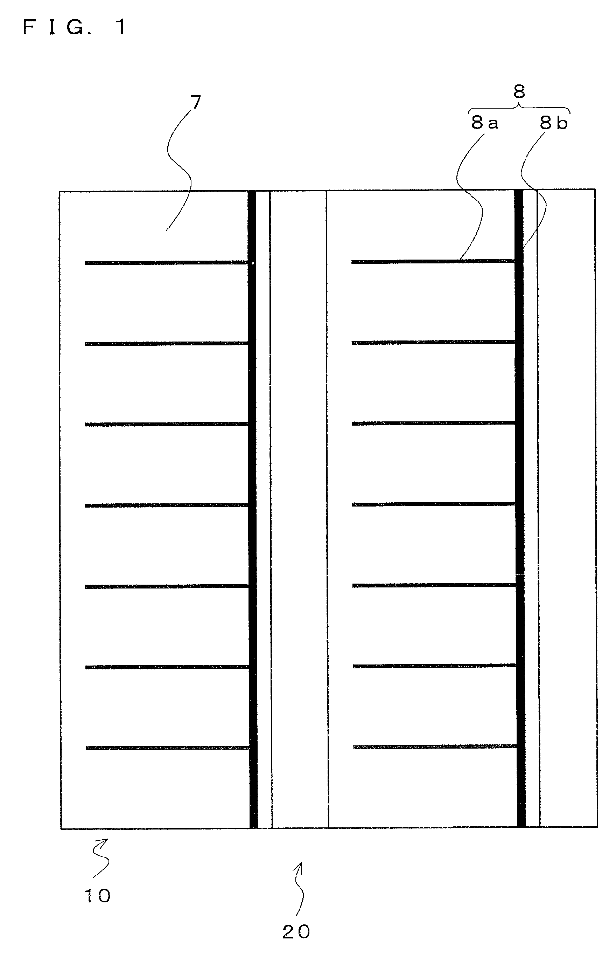

As in Fig. 1, a photoelectric conversion device 20 comprises a configuration including a plurality of photoelectric conversion elements 10 provided adjacent to each other on a substrate.

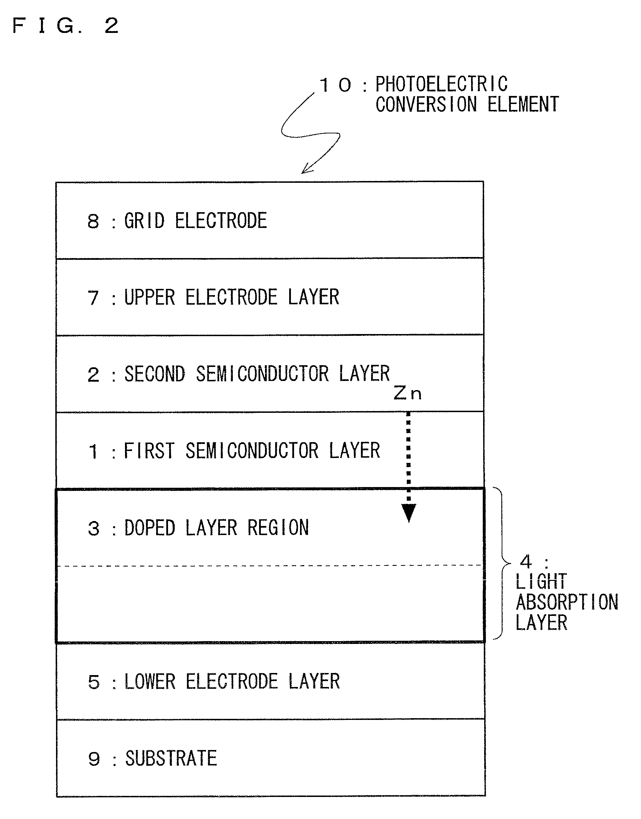

As in Fig. 2, each photoelectric conversion element 10 mainly includes, on a substrate 9, a lower electrode layer 5, a light absorption layer 4, a first semiconductor layer 1, a second semiconductor layer 2, an upper electrode layer 7, and a collector electrode 8 including a collecting section 8a and a connecting section 8b.

In addition, in Fig. 1, the principal surface on a side provided with the upper electrodes 7 and collector electrodes 8 serves as a light receiving surface in the photoelectric conversion device 20.

### <Substrate>

The substrate 9 is intended to support the plurality of photoelectric conversion elements 10. Materials to be used for the substrate 9 include glass, ceramic, resin, and metal. Blue plate glass (soda lime glass) on the order of 1 to 3 mm in thickness is used here as the substrate 9.

### <Lower Electrode>

The lower electrode layer 5 is a conductor which is provided on one principal surface of the substrate 9 and is comprised of a metal such as Mo, Al, Ti, Ta, or Au or a laminated structure of these metals. The lower electrode layer 5 is formed to have a thickness on the order of 0.2 to 1 µm with the use of a known thin film formation method such as a sputtering method or a vapor deposition method.

### <Light Absorption Layer>

The light absorption layer 4 is a p-type semiconductor layer mainly containing a chalcopyrite based (hereinafter, also referred to as a CIS based) I-III-VI group compound, which is provided on the lower electrode layer 5. This light absorption layer 4 has a thickness on the order of 1 to 3 µm.

The I-III-VI group compound herein refers to a compound of a I-B group element, a III-B group element, and a VI-B group element (in other words, also referred to as a group 11 element, a group 13 element, and a group 16 element), and Cu(In,Ga)Se₂ (hereinafter, also referred to as a CIGS) are cited as the present embodiment.

This light absorption layer 4 is able to be formed by a so-called vacuum process such as a sputtering method or a vapor deposition method, and additionally, can be also formed by a process referred to as a so-called application method or printing method in which a solution containing a constituent element of the light absorption layer 4 is applied onto the lower electrode layer 5, and then subjected to drying and a heat treatment.

### <First Semiconductor Layer>

The first semiconductor layer 1 is a semiconductor layer having an n-type conductivity type and containing a III-B group element and a VI-B group element, which is provided on the light absorption layer 4.

The first semiconductor layer 1 is provided in the form of heterojunction with the light absorption layer 4, when the light absorption layer 4 is comprised of a I-III-VI group compound semiconductor. Thus, when the second semiconductor layer 2 is formed on the first semiconductor layer 1, the light absorption layer 4 can be protected from damage.

Furthermore, the first semiconductor layer 1 may be formed by a CBD method (chemical bath deposition method) to have a thickness of, for example, 1 to 30 nm. This can diffuse a II-B group element from the second semiconductor layer 2 to the light absorption layer 4 to stably form a doped layer region 3 on the surface of the light absorption layer 4.

Furthermore, examples of the III-B group element contained in the first semiconductor layer 1 include In, Ga, etc. In addition, examples of the VI-B group element contained in the first semiconductor layer 1 include S, etc.

Furthermore, the first semiconductor layer 1 contains the II-B group element, and the concentration of the II-B group element in the first semiconductor layer 1 is higher on the second semiconductor layer 2 side than on the light absorption layer side 4. This improves the efficiency of the electrical junction between the first semiconductor layer 1 and the second semiconductor layer 2, and can match the first semiconductor layer 1 and the light absorption layer 4 in terms of lattice constant to reduce lattice defects.

Furthermore, the concentration of the II-B group element is supposed to be 1 to 40 atom% in the entire first semiconductor layer 1. The concentration of the II-B group element in the entire first semiconductor layer 1 herein refers to an average value in the case of performing a quantitative analysis in the thickness direction for the first semiconductor layer 1 by an EDS analysis or the like. Thus, further diffusion of the II-B group element from the second semiconductor layer 2 into the doped layer region 3 can be reduced during the use of the photoelectric conversion device 1. More specifically, the first semiconductor layer 1 can act to buffer the diffusion of the II-B group element, and stably maintain the p-n junction formed in the light absorption layer 4.

In addition, the first semiconductor layer 1 may contain oxygen (O) in the state of an oxide and/or a hydroxide. When the first semiconductor layer 1 contains O and S, the O concentration may be lower on the light absorption layer 4 side of the first semiconductor layer 1 than on the second semiconductor layer 2 side of the first semiconductor layer 1. Thus, the first semiconductor layer 1 on the light absorption layer 4 side has, as a result, a higher S proportion in place of O in the same group, so that the lattice constant can be made closer to that of the light absorption layer 4, thus improving the electrical junction between the light absorption layer 4 and the first semiconductor layer 1.

This first semiconductor layer 1 with a site different in O concentration can be prepared by, for example, a method such as changing the pH or S concentration in preparing the first semiconductor layer 1 by a CBD method.

In addition, when the O proportion is higher on the second semiconductor layer 2 side of the first semiconductor layer 1, the structures of In₂O₃ and In(OH)₃ may be increased on the second semiconductor layer 2 side. These structures can make a contribution to an improvement in conversion efficiency, because of their wider band gaps than that of In₂S3.

### <Second Semiconductor Layer>

The second semiconductor layer 2 is a semiconductor layer having an n-type conductivity type and containing an oxide of a II-B group element, which is provided on the first semiconductor layer 1.

Examples of the oxide of the II-B group element, which is contained in the second semiconductor layer 2, include, for example, a zinc oxide (ZnO) and a cadmium oxide (CdO). The second semiconductor layer 2 may be formed by a sputtering method, a vapor deposition method, etc.

The existence of this second semiconductor layer 2 reduces the generation of a leakage current between the upper electrode layer 7 and the light absorption layer 4.

### <Doped Layer Region>

Now, although a difference is produced between the explanation order and the stacking order, an embodiment of the present invention comprises the doped layer region 3 containing a II-B group element on the first semiconductor layer 1 side of the light absorption layer 4 as in Fig. 2. Examples of the II-B group element contained in the doped layer region 3 include Zn, Cd, etc. The doped layer region 3 containing the II-B group element serves as the n-type conductive layer in the light absorption layer 4, and a favorable p-n junction is thus formed in the light absorption layer 4. Therefore, the photoelectric conversion efficiency of the photoelectric conversion element is further improved.

Furthermore, when the thickness of the doped layer region 3 is 5 to 100 nm, the recombination of photogenerated carriers can be relatively reduced.

For example, when In₂S₃ is used for the first semiconductor layer 1, whereas ZnO is deposited as the second semiconductor layer 2, the n-type doped layer region 3 formed by doping the first semiconductor layer 1 side of the light absorption layer 4 with Zn, forms a p-n homojunction with the light absorption layer 4, provides more stability, and increases the conversion efficiency.

In this case, as long as the concentration of Zn in the doped layer region 3 is 1 to 30 atom%, the p-n junction is stabilized to increase the conversion efficiency, and the recombination of photogenerated carriers can be relatively reduced.

Furthermore, as long as the concentration of the I-B group element in the doped layer region 3 is lower than the concentration of the I-B group element in the other entire region of the light absorption layer 4, the deficiency of the I-B group element in the I-B group element makes the II-B group element more likely to be located at the site of the deficiency in I-B group element, thereby promoting the n-type of the doped layer region 3, stabilizing the p-n junction, and increasing the conversion efficiency.

When the light absorption layer 4 contains Cu as the I-B group element, contains In and Ga as the III-B group element, and contains Se as the VI-B group element, the concentrations of Cu, In, Ga, and Se in the doped layer region 3 may be respectively 5 atom% or more for Cu, 20 to 30 atom% for In, 5 to 15 atom% for Ga, and 35 to 55 atom% for Se. Thus, a p-n junction can be formed in a favorable manner in the light absorption layer 4.

### <Upper Electrode Layer>

The upper electrode layer 7 is an n-type transparent conductive film provided on the second semiconductor layer 2. The upper electrode layer 7 is provided as an electrode for extracting charges generated in photoelectric conversion through the second semiconductor layer 2.

In addition, the upper electrode layer 7 is comprised of a substance which has a lower resistivity than those of the first semiconductor layer 1 and the second semiconductor layer 2, for example, an indium oxide (ITO) containing tin, or the like. The upper electrode layer 7 is formed by a sputtering method, a vapor deposition method, or the like.

It is to be noted that the first semiconductor layer 1, the second semiconductor layer 2, and the upper electrode layer 7 may be comprised of substances which have a light transmitting property with respect to the wavelength range of light absorbed by the light absorption layer 4. In addition, as long as the first semiconductor layer 1, the second semiconductor layer 2, and the upper electrode layer 7 have substantially the same absolute refractive index, the light absorption efficiency in the light absorption layer 4 is further improved.

### <Collector Electrode>

The collector electrode 8 is comprised of the collecting section 8a and the connecting section 8b which are comprised of a metal such as Ag, and has a role in collecting charges generated in the photoelectric conversion element 10 and extracted in the upper electrode layer 7. This makes it possible to reduce the upper electrode layer 7 in thickness.

The collector electrode 8 may have a width of 50 to 400 µm in consideration of conductivity and light transmission to the light absorption layer 4.

### <Other Embodiments of Photoelectric Conversion Element and Photoelectric Conversion Device>

Next, a photoelectric conversion element and a photoelectric conversion device according to another embodiment of the present invention will be described.

In the photoelectric conversion element and the photoelectric conversion device, the second semiconductor layer 2 may further contain therein hydrogen (H). This can compensate lattice defects in the second semiconductor layer 2 with the H, and the power generation efficiency can be thus improved.

In addition, the first semiconductor layer 1 may contain therein H. This can compensate lattice defects in the first semiconductor layer 1 with the H, and the power generation efficiency can be thus improved.

In addition, the light absorption layer 4 may contain therein H. This can compensate lattice defects in the light absorption layer 4 with the H, and the power generation efficiency can be thus improved.

For these second semiconductor layer 2 containing H, first semiconductor layer 1 containing H, and light absorption layer 4 containing H, each layer can be doped with H by carrying out an annealing treatment in a hydrogen atmosphere.

### <Method for Manufacturing Photoelectric Conversion Element>

Next, a process for manufacturing a photoelectric conversion device which comprises the structure described above will be described.

A case of forming the light absorption layer 4 comprised of a I-III-VI group compound semiconductor (for example, a CIGS including Cu, In, Ga, and Se, or the like) by using an application method, and further forming the first semiconductor layer 1 and the subsequent layers will be described below as an example.

First, the lower electrode layer 5 comprised of Mo is deposited by a sputtering method over substantially the entire surface of a cleaned substrate 1. The light absorption layer 4 and the first semiconductor layer 1 are sequentially formed on the lower electrode layer 5.

Next, after the lower electrode layer 5 is formed, a solution for forming the light absorption layer 4 is applied to the surface of the lower electrode layer 5, and subjected to drying to form a coating, and the coating is subjected to a heat treatment to form the light absorption layer 4.

The solution for forming the light absorption layer 4 is prepared by dissolving a I-B group metal and a III-group metal directly in a solvent including a chalcogen element containing organic compound and a basic organic solvent, and supposed to be a solution in which the total concentration of the I-B group metal and III-group metal is 10 mass% or more. It is to be noted that it is possible to apply various methods such as a spin coater, screen printing, dipping, a spray, and a die coater, for the application of the solution.

The chalcogen element containing organic compound refers to an organic compound containing a chalcogen element. The chalcogen element refers to S, Se, or Te among the VI-B group elements. Examples of the chalcogen element containing organic compound include, for example, thiol, sulfide, selenol, and terenol. Dissolving a metal directly in a mixed solvent refers to mixing and dissolving a metal alone or raw metal of an alloy directly in a mixed solvent.

The drying is carried out, for example, under a reducing atmosphere. The drying temperature is, for example, 50 to 300°C. The heat treatment is carried out, for example, under a reducing atmosphere of a hydrogen atmosphere. The heat treatment temperature is, for example, 400 to 600°C.

Next, after the light absorption layer 4 is formed, the first semiconductor layer 1 is formed by a CBD method (a chemical bath deposition method). The thickness of the first semiconductor layer 1 can be a thickness to an extent that, for example, allow easy passage of the II-B group element (for example, Zn) for forming the doped layer region 3, and can protect the light absorption layer 4 from damage by sputtering in a subsequent step.

Next, after the first semiconductor layer 1 is formed, for example, a zinc oxide (ZnO) is formed by a sputtering method, a vapor deposition method, or the like, as the second semiconductor layer 2.

Next, after the second semiconductor layer 2 is formed, an indium oxide containing tin (ITO) or the like is formed by a sputtering method, a vapor deposition method, or the like as the upper electrode layer 7.

After the upper electrode layer 7 is formed, a conductive paste with a metal powder such as Ag dispersed in a resin binder or the like is printed in a pattern shape as the collector electrode 8, and solidified by drying for the formation thereof.

### <Method for Forming Doped Layer Region 3 (First Method)>

A method for forming the doped layer region 3 will be described below in an embodiment of the present invention. First, an example of a method (referred to as a first method) will be represented below in which the doped layer region 3 is formed by diffusing Zn contained in the second semiconductor layer 2 through the first semiconductor layer 1 into the light absorption layer 4.

As represented by the method for manufacturing the photoelectric conversion element, the light absorption layer 4, the first semiconductor layer 1, and the second semiconductor layer 2 are formed sequentially on the lower electrode layer (hereinafter, referred to as a stacking step). Then, after this stacking step, the II-B group element is diffused from the second semiconductor layer 2 through the first semiconductor layer 1 into the light absorption layer 4 (hereinafter, referred to as a diffusing step).

The diffusing step is carried out by an annealing treatment to the second semiconductor layer 2. From the viewpoint that the II-B group element is easily diffused, the composition ratio of the I-B group element may be made lower than the composition ratio of the III-B group element in at least the upper surface portion (on the first semiconductor layer 1 side) of the light absorption layer 4 formed in the stacking step. Thus, sites on the first semiconductor layer 1 side of the light absorption layer 4 will include a lot of I-B group deficient sites, and the II-B group element will easily diffuse to the I-B group deficient sites of the light absorption layer 4, thereby making it possible to form the doped layer region 3 in a favorable manner.

A method for forming the light absorption layer 4 will be represented below in which these sites on the first semiconductor layer 1 side of the light absorption layer 4 include I-B group element deficient sites.

First, in the heat treatment of the coating formed by applying a solution for forming the light absorption layer 4, the coating is kept at a relatively low temperature (100 to 400°C). Thus, the metal complex constituting the coating undergoes liquefaction by melting, and the organic constituent evaporates gradually. In this case, the I-B group element which has a relatively smaller solubility in the liquid metal complex than the other elements (III-B group elements and VI-B group elements) shows a tendency to be transferred to one principal surface side of the lower electrode layer 5 for preferential deposition. As a result, the light absorption layer 4 with Cu deficient sites can be formed on the first semiconductor layer 1 side.

Alternatively, the solution for forming the light absorption layer 4 may be applied in more than once, so that the I-B group element concentration of the solution applied last may be lowered.

In addition, the annealing treatment in the diffusing step may be carried out in a hydrogen atmosphere. This can diffuse the II-B group element of the second semiconductor layer 2 more easily, and prepare the doped layer region 3 easily. This is believed to be because the diffusion of the II-B group element is facilitated due to the fact that the bond between the mutually bonded II-B group element and oxygen is broken by hydrogen to isolate the II-B group element in the second semiconductor layer 2.

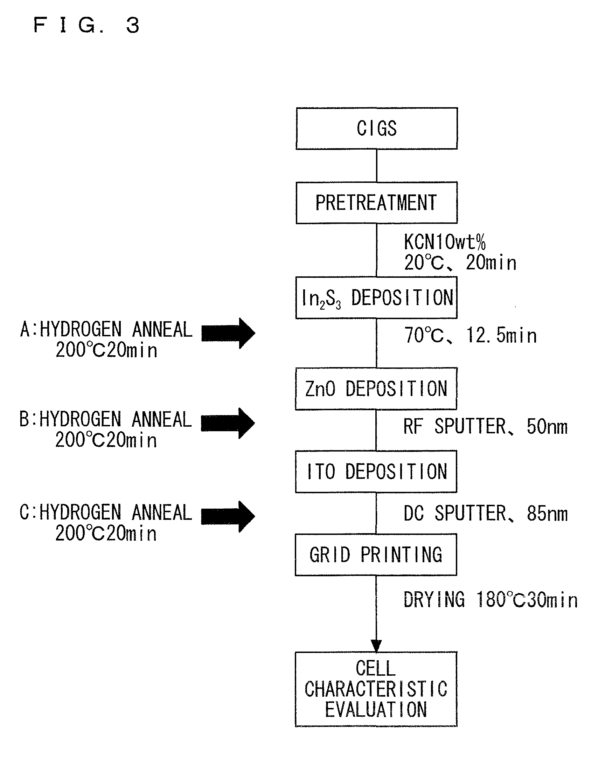

An example of a process for manufacturing the photoelectric conversion element 10 is shown in Fig. 3 herein. In this process, the timing of an annealing treatment in a hydrogen atmosphere includes stages A, B, and C shown in Fig. 3. The stage A herein shows that an annealing treatment (an annealing treatment at 200°C for 20 minutes in a hydrogen atmosphere) is carried out immediately after the formation of the first semiconductor layer 1 (corresponding to In₂S₃ in Fig. 3). In addition, the stage B shows that the annealing treatment is carried out immediately after the formation of the second semiconductor layer 2 (corresponding to ZnO in Fig. 3). In addition, the stage C shows that the annealing treatment is carried out immediately after the formation of the upper electrode layer 7.

Table 1 is the result of comparing series resistance values (Rs) for photoelectric conversion elements prepared while varying the timing of the annealing treatment as in Fig. 3, and a photoelectric conversion element subjected to no annealing treatment. The method for measuring the series resistance values (Rs) herein is implemented with electrode terminals placed on the upper electrode layer 7 and the lower electrode layer 5, in which the measurement range was adapted to fall within the range of -1 V to +1 V. In Table 1, the resistance value of the photoelectric conversion element subjected to no annealing treatment is regarded as 1 for normalization.

**[Table 1]**

| | Resistance Value (Ratio) |
|---|---|
| With no Hydrogen Anneal | 1 |
| With Hydrogen Anneal (Stage A) | 0.72 |
| With Hydrogen Anneal (Stage B) | 0.64 |
| With Hydrogen Anneal (Stage C) | 0.07 |

According to Table 1, as compared with the case of carrying out no annealing treatment, that is, the case without the doped layer region 3 formed, the Rs in the case of carrying out the annealing treatment is decreased in the order of the stages A, C, and B, showing a tendency that the property is improved in the order of the stages A, C, and B. In particular, the case of the annealing treatment at the stage of stage B results in a significant decrease in Rs, and thus a notable improvement in property. This is believed to be due to the following reason. While the diffusion of Zn from the second semiconductor layer 2 is caused a decrease in Rs in each of the annealing treatment at the stage B and the annealing treatment at the stage C, the Zn in the second semiconductor layer 2 is more likely to be isolated by hydrogen in the atmosphere particularly in the annealing treatment at the stage B. Therefore, it is believed that this isolated Zn diffuses to form the doped layer region 3 in the light absorption layer 4 in a favorable manner.

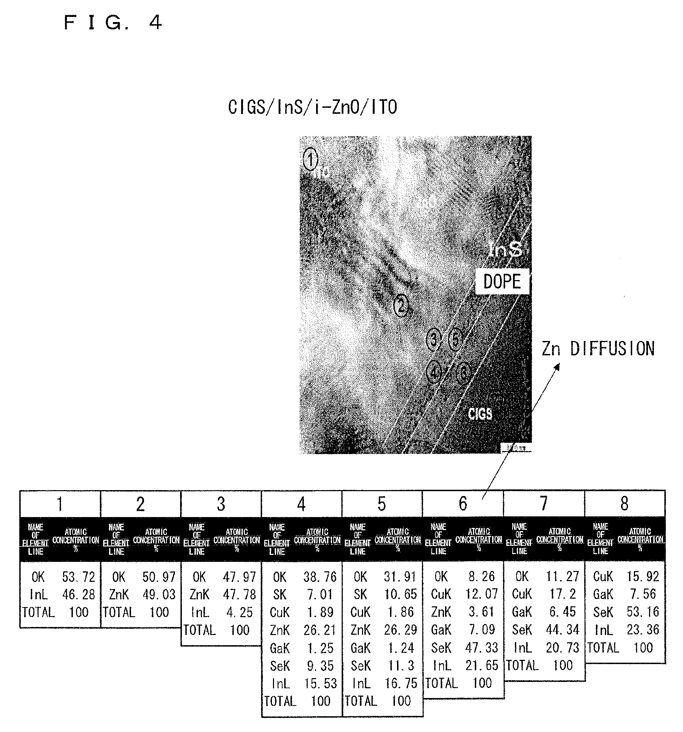

It is to be noted that Fig. 4 shows a photograph of a cross section of the photoelectric conversion element 10 prepared by carrying out the annealing treatment at the stage B. For respective circled measurement points shown in Fig. 4, the point 1 corresponds to the upper electrode layer 7, the points 2, 3 correspond to the second semiconductor layer 2, the points 4, 5 correspond to the first semiconductor layer 1, the point 6 corresponds to the doped layer region 3, and the point 7 corresponds to the light absorption layer 4. Elemental analysis results for each measurement point are shown below the photograph of the cross section. Thus, it is determined that the doped layer region 3 is formed in a favorable manner.

### <Method for Forming Doped Layer Region 3 (Second Method)>

Another example of the method for forming the doped layer region 3 will be described. An example of a method (referred to as a second method) will be represented now in which the doped layer region 3 is formed by implanting a II-B group element through the first semiconductor layer 1 into the light absorption layer 4, in the formation of the second semiconductor layer 2.

First, the light absorption layer 4 and the first semiconductor layer 1 are sequentially formed in the way described above. Next, in the formation of the second semiconductor layer 2, on the condition that the ion implantation intensity of sputtering is increased, the II-B group element in the second semiconductor layer 2 can be diffused through the first semiconductor layer 1 into the light absorption layer 4 in a favorable manner. This is believed to be due to a pinning effect (implantation effect) produced by the sputtering.

In this case, from the viewpoint that the II-B group element is easily implanted into the light absorption layer 4, the composition ratio of the I-B group element may be made lower than the composition ratio of the III-B group element in at least the upper surface portion (on the first semiconductor layer 1 side) of the light absorption layer 4. Thus, sites on the first semiconductor layer 1 side of the light absorption layer 4 will include a lot of I-B group deficient sites, and the II-B group element will be easily implanted into the I-B group deficient sites of the light absorption layer 4, thereby making it possible to form the doped layer region 3 in a favorable manner.

For a method for forming the foregoing light absorption layer 4 in which sites on the first semiconductor layer 1 side of the light absorption layer 4 include I-B group element deficient sites, the method represented by the first method can be adopted. Example

### (Sample Preparation Method)

A sample of a photoelectric conversion element (device) used in an example of the present invention will be described.

First, the lower electrode layer 5 comprised of Mo was deposited by a sputtering method over substantially the entire surface of a cleaned substrate 9.

Next, for the light absorption layer 4, a solution of a I-B group metal and a III-B group metal directly dissolved at 20 mass% in a solvent including a chalcogen element containing organic compound and a basic organic solvent was applied by a spin coater onto the surface of the lower electrode layer 5, the drying temperature was adapted to 150°C, and the heat treatment temperature was adapted to 400°C in a nitrogen atmosphere.

The first semiconductor layer 1 was formed by a CBD method (chemical bath deposition method), and after the first semiconductor layer 1 was formed, a zinc oxide (ZnO) was formed by a sputtering method as the second semiconductor layer 2.

After the second semiconductor layer 2 was formed, an indium oxide (ITO) containing tin was formed by a sputtering method as the upper electrode layer 7.

After the upper electrode layer 7 was formed, a conductive paste with a metal powder of Ag dispersed in a resin binder was printed in a pattern shape as the collector electrode 8, and solidified by drying for the formation thereof.

Then, the diffusion of Zn was achieved by an annealing treatment in a hydrogen atmosphere, which was achieved at a treatment temperature of 300°C for 40 minutes after the formation of the second semiconductor layer.

As a comparative example, a sample corresponding to Patent Document 1 was prepared by diffusing an n-type semiconductor into a light absorption layer of CIGS in the deposition of ZnS as a buffer layer by a CBD method (chemical bath deposition method), and matching the other conditions to the example of the present application (Sample Number 36).

### (Sample Evaluation Method)

For each of these photoelectric conversion devices 20, the conversion efficiency was measured. As for the method for composition analysis, each sample was subjected to FIB processing, and the cross section was then observed by a TEM to make an EDS analysis of the composition for each stacked section. The preparation conditions and evaluation results are shown below in Table 2.

**[Table 21**

| Sample Number | Zn Doped Layer | | | | | | Light Absorption Layer | First Semiconductor Layer | | Conversion Efficiency |
|---|---|---|---|---|---|---|---|---|---|---|
| | Thickness | Zn Concentration | Cu Concentration | In Concentration | Ga Concentration | Se Concentration | Cu Concentration | Thickness | Zn concentration | |
| | nm | atom% | atom% | atom% | atom% | atom% | atom% | nm | atom% | % |
| 1 | 4 | 15 | 10 | 25 | 10 | 45 | 15 | 0.5 | 20 | 9 |
| 2 | 5 | 15 | 10 | 25 | 10 | 45 | 15 | 1 | 20 | 11 |
| 3 | 50 | 15 | 10 | 25 | 10 | 45 | 15 | 15 | 20 | 11 |
| 4 | 100 | 15 | 10 | 25 | 10 | 45 | 15 | 30 | 20 | 10 |
| 5 | 200 | 15 | 10 | 25 | 10 | 45 | 15 | 30 | 20 | 9 |
| 6 | 50 | 0.5 | 10 | 25 | 10 | 45 | 15 | 40 | 20 | 9 |
| 7 | 50 | 1 | 10 | 25 | 10 | 45 | 15 | 15 | 20 | 10 |
| 8 | 50 | 30 | 10 | 25 | 10 | 45 | 15 | 15 | 20 | 10 |
| 9 | 50 | 40 | 10 | 25 | 10 | 45 | 15 | 15 | 20 | 9 |
| 10 | 50 | 15 | 4 | 25 | 10 | 45 | 15 | 15 | 20 | 9 |
| 11 | 50 | 15 | 5 | 25 | 10 | 45 | 15 | 15 | 20 | 10 |
| 12 | 50 | 15 | 25 | 25 | 10 | 45 | 15 | 15 | 20 | 10 |
| 13 | 50 | 15 | 30 | 25 | 10 | 45 | 15 | 15 | 20 | 9 |
| 14 | 50 | 15 | 10 | 15 | 10 | 45 | 15 | 15 | 20 | 10 |
| 15 | 50 | 15 | 10 | 20 | 10 | 45 | 15 | 15 | 20 | 11 |
| 16 | 50 | 15 | 10 | 30 | 10 | 45 | 15 | 15 | 20 | 11 |
| 17 | 50 | 15 | 10 | 35 | 10 | 45 | 15 | 15 | 20 | 10 |
| 18 | 50 | 15 | 10 | 25 | 4 | 45 | 15 | 15 | 20 | 9 |
| 19 | 50 | 15 | 10 | 25 | 5 | 45 | 15 | 15 | 20 | 10 |
| 20 | 50 | 15 | 10 | 25 | 15 | 45 | 15 | 15 | 20 | 10 |
| 21 | 50 | 15 | 10 | 25 | 20 | 45 | 15 | 15 | 20 | 9 |
| 22 | 50 | 15 | 10 | 25 | 10 | 30 | 15 | 15 | 20 | 8 |
| 23 | 50 | 15 | 10 | 25 | 10 | 35 | 15 | 15 | 20 | 9 |
| 24 | 50 | 15 | 10 | 25 | 10 | 55 | 15 | 15 | 20 | 11 |
| 25 | 50 | 15 | 10 | 25 | 10 | 60 | 15 | 15 | 20 | 10 |
| 26 | 50 | 15 | 10 | 25 | 10 | 45 | 10 | 15 | 20 | 10 |
| 27 | 50 | 15 | 10 | 25 | 10 | 45 | 20 | 15 | 20 | 12 |
| 28 | 50 | 15 | 10 | 25 | 10 | 45 | 15 | 0.5 | 20 | 10 |
| 29 | 50 | 15 | 10 | 25 | 10 | 45 | 15 | 1 | 20 | 11 |
| 30 | 50 | 15 | 10 | 25 | 10 | 45 | 15 | 30 | 20 | 9 |
| 31 | 50 | 15 | 10 | 25 | 10 | 45 | 15 | 40 | 20 | 8 |
| 32 | 50 | 15 | 10 | 25 | 10 | 45 | 15 | 15 | 0.5 | 10 |
| 33 | 50 | 15 | 10 | 25 | 10 | 45 | 15 | 15 | 1 | 11 |
| 34 | 50 | 15 | 10 | 25 | 10 | 45 | 15 | 15 | 40 | 11 |
| 35 | 50 | 15 | 10 | 25 | 10 | 45 | 15 | 15 | 50 | 10 |
| 36 | Zn Diffusion into Entire Light Absorption Layer | | | | | | 15 | 15 | 20 | 6 |

The conversion efficiency was only on the order of 6% in the case of sample 36 as a comparative example, whereas each sample was able to achieve a higher conversion efficiency in the example of the present invention. This is assumed to be due to the fact that Zn is diffused into the entire light absorption layer 4.

In the case of samples 1 to 5, as long as the thickness of the doped layer region 3 was 5 to 100 nm (samples 2 to 4), the samples achieved adequate p-n junctions, and were able to achieve higher conversion efficiencies without any recombination of carriers, indicating that the samples are more preferable.

In the case of samples 6 to 9, as long as the Zn concentration near the center of the doped layer region 3 was 1 to 30 atom% (7, 8), the samples achieved adequate p-n junctions, and were able to achieve higher conversion efficiencies without any recombination of carriers, indicating that the samples are more preferable.

In the case of samples 10 to 13, as long as the Cu concentration of the doped layer region 3 was 5 atom% or more (samples 11, 12), the samples were able to achieve desired conversion efficiencies, because Zn is not excessively transferred to the light absorption layer 4.

In the case of samples 14 to 17, as long as the In concentration of the doped layer region 3 was 20 to 30 atom% (samples 15, 16), the samples were able to achieve higher conversion efficiencies, indicating that the samples are more preferable.

In the case of samples 18 to 21, as long as the Ga concentration of the doped layer region 3 was 5 to 15 atom% (samples 19, 20), the samples were able to achieve higher conversion efficiencies, indicating that the samples are more preferable.

In the case of samples 22 to 25, as long as the Se concentration of the doped layer region 3 was 35 to 55 atom% (samples 23, 24), the samples were able to achieve higher conversion efficiencies, indicating that the samples are more preferable.

In the case of samples 26 and 27, the samples were obtained by varying the Cu composition in the light absorption layer from 10 to 20 atom%, and it is determined that the conversion efficiencies are not affected greatly within this range.

In the case of samples 28 to 31, as long as the thickness of the first semiconductor layer 1 is 1 to 30 nm (samples 29, 30), it is easy to transfer Zn from the second semiconductor layer 2 to the light absorption layer 4, and the second semiconductor layer 2 can protect the light absorption layer 4 from stacking damage. Thus, the samples were able to achieve higher conversion efficiencies, indicating that the samples are more preferable.

In the case of samples 32 to 35, as long as the Zn concentration of the first semiconductor layer 1 was 1 to 40 atom% (samples 33, 34), Zn was transferred in just proportion from the second semiconductor layer 2 to the light absorption layer 4, and the samples were able to achieve higher conversion efficiencies, indicating that the samples are more preferable.

It is to be noted that the present invention is not limited to the embodiments described above and is also intended to encompass any combination of the embodiments described above.

### Description of Symbols

- 1:: first semiconductor layer
- 2:: second semiconductor layer
- 3:: doped layer region
- 4:: light absorption layer
- 5:: lower electrode layer
- 7:: upper electrode layer
- 8:: collector electrode
- 8a:: collecting section
- 8b:: connecting section
- 9:: substrate
- 10:: photoelectric conversion element
- 20:: photoelectric conversion device

## Claims

1. A photoelectric conversion element comprising:
a light absorption layer containing a I-B group element, a III-B group element, and a VI-B group element, which is provided on a lower electrode layer;
a first semiconductor layer containing a III-B group element and a VI-B group element, which is provided on the light absorption layer; and
a second semiconductor layer containing an oxide of a II-B group element, which is provided on the first semiconductor layer,
wherein the light absorption layer comprises a doped layer region containing the II-B group element, on the first semiconductor layer side.

2. The photoelectric conversion element according to claim 1, wherein a thickness of the doped layer region is 5 to 100 nm.

3. The photoelectric conversion element according to claim 1 or 2, wherein the first semiconductor layer comprises In and S, the second semiconductor layer comprises ZnO, and the doped layer region comprises Zn.

4. The photoelectric conversion element according to claim 3, wherein a Zn concentration in the doped layer region is 1 to 30 atom%.

5. The photoelectric conversion element according to any of claims 1 to 4, wherein the light absorption layer comprises Cu as a I-B group element, comprises In and Ga as III-B group elements, and comprises Se as a VI-B group element,
concentrations of Cu, In, Ga, and Se in the doped layer region are respectively 5 atom% or more for the Cu, 20 to 30 atom% for the In, 5 to 15 atom% for the Ga, and 35 to 55 atom% for the Se.

6. The photoelectric conversion element according to any of claims 1 to 5, wherein a thickness of the first semiconductor layer is 1 to 30 nm.

7. The photoelectric conversion element according to any of claims 1 to 6, wherein the first semiconductor layer comprises a II-B group element, and
a concentration of the II-B group element is higher on the second semiconductor layer side than on the light absorption layer side in the first semiconductor layer.

8. The photoelectric conversion element according to claim 7, wherein the concentration of the II-B group element is 1 to 40 atom% in the entire first semiconductor layer.

9. A photoelectric conversion device using the photoelectric conversion element according to any of claims 1 to 8.

10. A method for manufacturing a photoelectric conversion element comprising: a stacking step of sequentially forming, on a lower electrode layer, a light absorption layer containing a I-B group element, a III-B group element, and a VI-B group element, a first semiconductor layer containing a III-B group element and a VI-B group element, and a second semiconductor layer containing an oxide of a II-B group element; and
a diffusing step of diffusing the II-B group element from the second semiconductor layer through the first semiconductor layer to the light absorption layer, after the stacking step.

11. The method for manufacturing a photoelectric conversion element according to claim 10, wherein the diffusing step is a step of subjecting the second semiconductor layer to an annealing treatment in a hydrogen atmosphere.

12. A method for manufacturing a photoelectric conversion element comprising: a stacking step of sequentially forming, on a lower electrode layer, a light absorption layer containing a I-B group element, a III-B group element, and a VI-B group element, and a first semiconductor layer containing a III-B group element and a VI-B group element; and
a deposition step of depositing, on the first semiconductor layer, a second semiconductor layer containing an oxide of a II-B group element while implanting the II-B group element through the first semiconductor layer into the light absorption layer.

13. The method for manufacturing a photoelectric conversion element according to claim 12, wherein a layer in which a composition ratio of the I-B group element is lower than a composition ratio of the III-B group element in at least a surface portion on a side opposite to the lower electrode layer is formed as the light absorption layer in the stacking step, and
the second semiconductor layer is formed by sputtering in the deposition step.
